# EUROPEAN PATENT APPLICATION

(11) **EP 3 091 103 A1**
(43) Date of publication of application: **09.11.2016**
(21) Application number: 15166292.1
(22) Date of filing: 04.05.2015
(51) Int. Cl.: C23C 18/06, C23C 18/12, C23C 18/14

(54) **PROCESS FOR OBTAINING PATTERNED METAL-OXIDE THIN FILMS DEPOSITED ONTO A SUBSTRATE, FILMED SUBSTRATES OBTAINED THEREOF, AND SEMICONDUCTOR NANODEVICES COMPRISING THEM**

(71) Applicant: CENTRE NATIONAL DE LA RECHERCHE SCIENTIFIQUE, 75794 Paris Cedex 16 (FR)
(72) Inventor: Soppera, Olivier, 68100 Mulhouse (FR); Zan, Hsiao-Wen, Hsinchu City 300 (TW); Lin, Hung-Cheng, Hsinchu City 300 (TW); Li, Chang-Hung, New Taipai City 22067 (TW); Stehlin, Fabrice, 68480 Moernach (FR); Spangenberg, Arnaud, 68720 Flaxlanden (FR); Wleder, Fernand, 68640 Muespach-le- Haut (FR)
(74) Representative: Vidon Brevets & Stratégie

(57) **Abstract**

A process for obtaining patterned metal-oxide thin films deposited onto substrates is provided, as well as filmed substrates obtained thereof, and semiconductor devices comprising them. The process comprises the steps of:

- preparing a metal oxide chelate solution by complexing metal oxide precursors with a ligand in an alcoholic solvent, wherein the ligand is methacrylic acid, for obtaining a metal oxide chelate;

- preparing a metal oxo-cluster solution by submitting the metal oxide chelate solution to water hydrolysis, for obtaining a partially-condensed metal oxide chelate;

- preparing a doped-metal oxide solution by doping the metal oxo-cluster solution with a doping material comprising a metal element;

- depositing the doped-metal oxide solution onto a substrate, for obtaining a substrate coated with a metal oxide thin film;

- patterning the coated substrate by irradiating it with deep ultra-violet (DUV) wavelengths, for obtaining a patterned coating;

- immersing the substrat comprising a patterned coating into a development media, for obtaining a developed patterned substrate;

- post-annealing the developed patterned substrate, for obtaining a fully inorganic patterned substrate.

The present invention belongs to the field of semiconductor nanodevices.

## Description

### TECHNICAL FIELD OF THE INVENTION

The present invention relates to processes for obtaining patterned metal-oxide thin films deposited onto substrates, the filmed substrates obtained thereof, and semiconductor devices comprising them. The present invention belongs to the field of semiconductor nanodevices.

### BACKGROUND

In many fields, such as in electronics, optics, photonics, photovoltaic, photocatalysis, biology, electrochemistry and electromechanics, there is an increasing need in providing semiconductor nanodevices, i.e. semiconductor articles having dimensions ranging from about 1 to about 100 nm. These articles may be used in many different applications, particularly in active-matrix displays, such as displays, sensor arrays, solar-cells, transistors, and X-ray detectors.

Over the past years, it has been shown particularly interesting to obtain devices comprising a substrate and a patterned metal-oxide thin film deposited onto it. The deposited patterned metal-oxide thin film usually has semiconductor properties, and is associated with various advantages. For practical applications, a patterning is required, with size structures ranging from mm to nm scales, depending on the final device properties. Particularly, such nanostructures may be processed as solution, easing the manufacturing process. They also exhibit a high transparency in visible light, allowing the manufacturing of transparent electronics. They are also robust, with a satisfactory inertness towards chemical, temperatures, and pressure. They exhibit also for example high electron mobility, flexibility, and good air stability.

It is known already various processes for obtaining patterned metal-oxide thin films deposited onto a substrates. Such processes aim at tackling various needs and/or issues, including the implementation of simple and low-cost, non-vacuum, and/or photoresist-free processes; controllability of the shape, size, uniformity, and/or thickness of the deposited films; reduction of process steps; avoidance of toxic and high-cost chemicals; compatibility with temperature sensitive substrates e.g. plastic substrates. Suitable processes for obtaining semiconductor metal oxide nanostructures have been disclosed for example in the following publications: Y.H. Kim, Nature, vol.489, 6 September 2012, 128; Y.-H. Lin, Adv. Mater. 2013, 25, 4340-4346; Y. S. Rim et al., ACSNANO, vol.8, n°9, 9680-9686, 2014); H. S. Lim et al., Scientific Reports, 4:4544, DOI:10.1038/srep04544; J. H. Kim et al., ACS Appl. Master. Interfaces 2014, 6, 4819-4822. One of the drawbacks associated with these known technologies lies on the low photosensitivity of the proposed precursor solution at the working wavelength, limiting particularly the possibility of resolution by photopatterning.

There is the constant need thereof for providing improved processes for obtaining patterned metal-oxide thin films deposited onto a substrate.

There is also the need for obtaining patterned metal-oxide thin films, deposited onto a substrate, exhibiting superior semiconductor properties.

There is also the need of obtaining patterned metal-oxide thin films, deposited onto a substrate, being adapted to applications requiring high resolution.

There is also the need of providing a process, being of lower cost and simpler implementation, particularly a process requiring using less materials.

### SUMMARY OF THE INVENTION

According to a first aspect, the present invention relates to a process for obtaining patterned metal-oxide thin films deposited onto a substrate, said process comprising the steps of:
- preparing a metal oxide chelate solution by complexing metal oxide precursors with a ligand in an alcoholic solvent, wherein the ligand is methacrylic acid, for obtaining a metal oxide chelate;
- preparing a metal oxo-cluster solution by submitting the metal oxide chelate solution to water hydrolysis, for obtaining a partially-condensed metal oxide chelate;
- preparing a doped-metal oxide solution by doping the metal oxo-cluster solution with a doping material comprising a metal element;
- depositing the doped-metal oxide solution onto a substrate, for obtaining a substrate coated with a metal oxide thin film;
- patterning the coated substrate by irradiating it with deep ultra-violet (DUV) wavelengths, for obtaining a patterned coating;
- immersing the substrat comprising a patterned coating into a development media, for obtaining a developed patterned substrate;
- post-annealing or post-exposing by DUV the developed patterned substrate, for obtaining a fully inorganic patterned substrate.

The inventors have provided an improved process for obtaining a patterned metal-oxide thin film deposited onto a substrate, by carefully selecting the process steps to be carried out, and the materials to be used. In particularly, the inventors have demonstrated the superiority of a process comprising - amongst other steps - a complexation step using a specific ligand, then a partial condensation step, then an irradiation step with DUV wavelengths, and then a post-annealing or post-exposing DUV step.

Indeed, the use of methacrylic acid as a ligand in the complexation step has shown particularly beneficial when carrying out subsequently an irradiation step with DUV wavelengths, as methacrylic acid bounded to transition metal exhibits high sensitivity in the DUV range, allowing light-induced crosslinking. Using methacrylic acid allows obtaining therefore metal oxide chelate being particularly suitable for use with DUV light source, especially considering the high optical absorption at specific wavelengths. It further allows mitigating the loss of resolution, which may be observed when using a DUV light source, particularly because of the incident heating, spreading to the non-irradiated parts of the substrate, inducing unwanted crosslinking. In addition, the implementation of a partial condensation step has shown particularly useful, when combined with a complexation step using a specific ligand and a partial condensation step, in that it prevents dewetting to occur.

In addition, the preparation of metal oxo clusters as host matrixes enables an efficient conversion from the solution to the solid state by thermal and/or photochemical annealing, the metal oxo-cluster acting as the precursor of the final metal oxide network. The metal oxide network is thus preformed in molecular scale species. Moreover, the control of the size of the metal oxo-cluster guarantees nanoscale resolution. The control of the surface chemistry of the metal oxo-clusters allows finely tuning the affinity of the clusters to the surface of the substrate, which is another important parameter for any application.

The use of photochemical process of the present invention, for preparing the final material, has shown several advantages. Firstly, the semiconductor nanostructures can be prepared by direct write, which considerably simplifies the process of integration and enables the integration of the semiconducting material upon specific conditions (flexible substrates, atmospheric conditions, etc.). Secondly, the DUV irradiation of the material allows freezing the material at room temperature, helping thereof controlling the homogeneity of the material at atomic scale and thus its physical properties (namely electrical properties).

The metal oxide precursors may comprise metal elements selected from the group consisting of zirconium (Zr), titanium (Ti), hafnium (Hf), zinc (Zn), aluminium (Al), and mixtures thereof; alternatively selected from the group consisting of Zr, Ti, and mixtures thereof.

The metal oxide precursors may be selected from the group consisting of metal alcoxide, metal acetate, metal citrate dihydrate, metal acetate dihydrate, metal acetylacetonate hydrate, metal acrylate, metal chloride, metal diethyldithiocarbamate, metal dimethyldithiocarbamate, metal fluoride, metal fluoride hydrate, metal hexafluoroacetylacetonate dihydrate, metal methacrylate, metal nitrate hexahydrate, metal nitrate hydrate, metal trifluoromethanesulfonate, metal undecylenate, metal trifluoroacetate hydrate, metal tetrafluoroborate hydrate, metal perchlorate hexahydrate, and mixtures thereof; alternatively selected from the group consisting of metal alcoxide ; alternatively selected from the group consisting of metal propoxide, metal isopropoxide, and mixtures thereof; alternatively selected from the group consisting of Zr(O-i-Pr)₄, Hf(O-i-Pr)₄, Ti(O-i-Pr)₄, Zn(O-i-Pr)₄, Al(O-i-Pr)₄ and mixtures thereof.

The alcoholic solvent may be selected from the group consisting of propanol, isopropanol, 2-methoxyethanol, ethanol, methanol, dimethylformamide, acetylacetone, dimethylamineborane, acetonitrile, cyclohexane, and mixtures; alternatively selected from the group consisting of propanol, isopropanol, 2-methoxyethanol, ethanol, methanol and mixtures thereof; alternatively the alcoholic solvent is propanol.

The doping material comprises a metal element, wherein the metal element may be selected from the group consisting of indium (In), gallium (Ga), tin (Sn), thallium (Tl), copper (Cu), and mixtures thereof; alternatively wherein the metal element may be In.

The doping material may be selected from the group consisting of metal nitrate, metal chloride, metal chloride tetrahydrate, metal fluoride, metal fluoride trihydrate, metal hydroxide, metal acetate hydrate, metal acetylacetonate, metal acetate, metal chloride pentahydrate, metal cyclopentadienide, metal formate, metal hexafluoroacetylacetonate, metal trifluoroacetate, metal perchlorate hydrate, and mixtures thereof; alternatively the doping material may be metal nitrate.

In a particular embodiment, the doping material is In(NO₃)₃.

The technique for depositing the metal oxide thin film onto the substrate may be chosen from the group consisting of spin-coating, dip-coating, spray-coating, inkjet, screen-printing; alternatively the technique for depositing the metal oxide thin film onto the substrate from the group may consist of spin-coating.

The deposition of the metal oxide thin film onto the substrate may be conducted at room temperature, under atmospheric conditions, and under controlled humidity.

It may be obtained a thin film deposited onto the substrate, wherein said thin film has a thickness ranging from about 10nm to about 500nm; preferably from about 20nm to about 200nm; more preferably from about 80nm to about 120nm.

The substrate may be made of suitable materials. The substrate may be selected from the group consisting of glass, silicon, silicon dioxide, aluminium oxide, sapphire, germanium, gallium arsenide, an alloy of silicon and germanium, indium phosphide, plastic such as polyimide), textiles or their combinations thereof; alternatively the substrate is silicon.

The technique for irradiating the film substrate may be a spatially-controlled irradiation; alternatively the technique may be photolithography using DUV lamp or lasers; alternatively the technique may be laser direct write lithography or interference lithography.

In a particular embodiment, the coated substrate is irradiated via a laser emitting DUV wavelengths. The coated substrate may be irradiated at a UV wavelengths of about 300nm or less; alternatively at a UV wavelengths ranging from about 180nm to about 270nm; alternatively at a UV wavelengths of about 193nm +/- about 0,5 nm or at a UV wavelengths of about 244nm +/- about 0,5 nm.

The development media may be an organic solvent; alternatively the development media may be selected from the group consisting of an alcohol, cyclohexanone, and mixtures thereof; alternatively from the group consisting of ethanol, 2-methoxyethanol, propanol, isopropanol, cyclohexanone and mixtures thereof. In an alternative, the development may be an aqueous solution; alternatively an acid aqueous solution or a basic aqueous solution.

The patterned substrate may be immersed into the organic solvent from 1sec to 180sec.

The developed patterned substrate may be post-annealed by thermal and/or photochemical treatment.

The thermal treatment may be carried out at a temperature ranging from about 100°C to about 800°C; preferably at a temperature ranging from about 250°C to about 600°C; more preferably at a temperature ranging from about 300°C to about 450°C. Simultaneously to the thermal treatment, a photochemical treatment may be applied using a DUV laser or DUV lamp.

According to a second aspect, the present invention relates to substrate, onto which it is deposited a patterned metal-oxide thin films, said patterned thin-film being obtained with the process according to the first aspect of the invention.

According to a third aspect, the present invention relates to a semiconductor device comprising the substrate, onto which a patterned metal-oxide thin films is deposited, according to the second aspect of the invention.

### FIGURES

Figure 1a is a photograph of a patterned metal-oxide thin film deposited onto the substrate (30x30 micron squares), when using an In-doped ZrO₂ solution (Zr:In ratio of 1:1) and mask lithography.
Figure 1b is a photograph of a patterned metal-oxide thin film deposited onto the substrate (30x30 micron squares), when using an In-doped ZrO₂ solution (Zr:In ratio of 1:2) and mask lithography.
Figure 1c is a photograph of a patterned metal-oxide thin film deposited onto the substrate (30x30 micron squares), when using an In-doped ZrO₂ solution (Zr:In ratio of 1:5) and mask lithography.
Figure 2 is the graphic representation of the electric current density (A/cm2) of metal-oxide thin films deposited onto the substrate, in function of the voltage (V) for various ratio Zr:In.
Figure 3 is a graphic representation of the absolute value of drain current (in log scale, Ampere) and the square root of the absolute value of the drain current (square root of Ampere) in function of the gate voltage (Volt) for various post-annealing temperatures.
Figure 4a is an Atomic Force Microscopy image of a patterned metal-oxide thin film deposited onto the substrate, when using an In-doped ZrO₂ solution (Zr:In ratio of 1:0.2), and laser interferometry lithography, with line width of 300 nm.
Figure 4b is an Atomic Force Microscopy image of a patterned metal-oxide thin film deposited onto the substrate, when using an In-doped ZrO₂ solution (Zr:In ratio of 1:0.2), and laser interferometry lithography, with line width of 300 nm.

### DETAILLED DESCRIPTION

The present process comprises the step of preparing a metal oxide chelate solution by complexing metal oxide precursors with a ligand in an alcoholic solvent, wherein the ligand is methacrylic acid. This step is called herein "complexation step". It is obtained a metal oxide chelate.

The complexation step may be implemented by adding the ligand to the metal oxide precursor solution, then stirring the mixture obtained from about 1 min to about 60 min, then adding the alcoholic solvent to the stirred mixtures obtained, then stirring the mixture obtained from about 1 min to about 60 min.

The metal oxide precursors may comprise metal elements selected from the group consisting of zirconium (Zr), titanium (Ti), hafnium (Hf), zinc (Zn), aluminium (Al), and mixtures thereof; alternatively selected from the group consisting of Zr, Ti, and mixtures thereof. The selection of these materials, particularly Zr and Ti, have shown particularly advantageous, in that they show a good stability over time, in that the films obtained have a good adhesion on most substrates, in that they form films with good optical quality and in that they provide improved photosensitivity allowing micro and nanoscale patterning.

The metal oxide precursors may be selected from the group consisting of metal alcoxide, metal acetate, metal citrate dihydrate, metal acetate dihydrate, metal acetylacetonate hydrate, metal acrylate, metal chloride, metal diethyldithiocarbamate, metal dimethyldithiocarbamate, metal fluoride, metal fluoride hydrate, metal hexafluoroacetylacetonate dihydrate, metal methacrylate, metal nitrate hexahydrate, metal nitrate hydrate, metal trifluoromethanesulfonate, metal undecylenate, metal trifluoroacetate hydrate, metal tetrafluoroborate hydrate, metal perchlorate hexahydrate, and mixtures thereof; alternatively selected from the group consisting of metal alcoxide ; alternatively selected from the group consisting of metal propoxide, metal isopropoxide, and mixtures thereof; alternatively selected from the group consisting of Zr(O-i-Pr)₄, Hf(O-i-Pr)₄, Ti(O-i-Pr)₄, Zn(O-i-Pr)₄, Al(O-i-Pr)₄ and mixtures thereof. The selection of metal oxide precursors being selected from the group consisting of metal propoxide, metal isopropoxide, and mixtures thereof have shown particularly advantageous, in that they have a good reactivity with methacrylic acid to form metal oxo-clusters with good stability in time and good photosensitivity.

The ratio ligand:metal may range from about 0.5:1 to about 10:1. The ratio ligand:metal is of importance for controlling the morphology of the metal oxo-clusters and their properties. In particular, this parameter is important for controlling the stability of the solution over time, as well as its photosensitivity.

The alcoholic solvent may be selected from the group consisting of propanol, isopropanol, 2-methoxyethanol, ethanol, methanol, dimethylformamide, acetylacetone, dimethylamineborane, acetonitrile, cyclohexane, and mixtures; alternatively selected from the group consisting of propanol, isopropanol, 2-methoxyethanol, ethanol, methanol and mixtures thereof; alternatively the alcoholic solvent is propanol.

It has been shown particularly advantageous selecting metal oxide precursors being selected from the group consisting of metal propoxide, metal isopropoxide, and mixtures thereof, together with the alcoholic solvent being propanol. Indeed, in this case, the solvent corresponds to the molecular species released after complexation of the propoxide precursor by ligand and thus any problem of chemical incompatibility is avoided.

In a particular embodiment, the complexation step is implemented in absence of additives such as acetylacetone, benzoylacetone, ammonium hydroxide.

The present process further comprises the step of preparing a metal oxo-cluster solution by submitting the metal oxide chelate solution to water hydrolysis. This step is called herein "partial condensation step". It is obtained a partially-condensed metal oxide chelate. This step is important for completing the formation of metal oxo-clusters and for modifying their surface chemistry, which allows having hydroxile groups driving up the adhesion of the material onto hydrophilic substrates such as silicon or glass.

The partial condensation step may be implemented by adding water (acid or basic conditions) to the metal oxide chelate solution, with ratio metal:water being comprised between about 1:0.1 and about 1:1000, then stirring the mixture obtained from about 1 min to about 60 min.

The present process may further comprise the step of aging the metal oxo-cluster solution from about 10 min to about 48 h, after carrying out the partial condensation step. This step is called herein "aging step". Implementing an aging step is recommended for obtaining metal oxo-clusters in solution, as their formation reaction may be a slow process. The addition of an aging step (and therefore the application a sufficient aging time) would help the solution to spread on the substrate (dewetting) and to adhere well on the substrate.

The present process may further comprise the step of adding further alcoholic solvent in the metal oxo-cluster solution, obtained after the partial condensation step or the aging step. This step is called herein "addition step". Suitable alcoholic solvents are defined hereinbefore. This addition step allows adapting the viscosity of the metal oxide chelate solution.

The viscosity of the metal oxide chelate solution may range from to about 1cP to about 500cP.

The present process further comprises the step of preparing a doped-metal oxide chelate solution by doping the metal oxo-cluster solution with a doping material comprising a metal element. This step is called herein "doping step". It is obtained a doped-metal oxide chelate solution.

The doping step may be implemented by adding the doping material to the metal oxo-cluster solution, then stirring the obtained mixture from about 1 min to about 60 min.

The doping material comprises a metal precursor, wherein the metal precursor may be selected from the group consisting of indium (In), gallium (Ga), tin (Sn), thallium (Tl), copper (Cu), and mixtures thereof; alternatively wherein the metal element may be In. The provision of a doping material comprising these metal elements, particularly In, has shown particularly advantageous in that it leads to materials with interesting semiconducting properties, especially in terms of mobility. Moreover, In precursors have proven to limit the alteration of the photosensitivity of the oxo-cluster host matrix, allowing, unlike other materials, high-resolution photolithography.

The doping material may be selected from the group consisting of metal nitrate, metal chloride, metal chloride tetrahydrate, metal fluoride, metal fluoride trihydrate, metal hydroxide, metal acetate hydrate, metal acetylacetonate, metal acetate, metal chloride pentahydrate, metal cyclopentadienide, metal formate, metal hexafluoroacetylacetonate, metal trifluoroacetate, metal perchlorate hydrate, and mixtures thereof; alternatively the doping material may be metal nitrate. The provision of these doping material, particularly a doping material being a metal nitrate, has shown particularly advantageous in that nitrate metals undergo photolysis under DUV that contributes to the formation of an homogeneous metal oxide polymetal network associated with good electrical properties.

In a particular embodiment, the doping material is In(NO₃)₃. The provision of a doping material being In(NO₃)₃ has shown particularly advantageous in that the electrical properties of the matrix doped with In(NO₃)₃ show interesting semiconducting properties (among them, mobility) that are suitable for practical applications.

The molar ratio between the metal oxide precursor and the doping material having a metal element may range from about 1:0.1 to about 1:10. Particularly, when the metal oxide precursor comprises metal elements selected from the group consisting of Zr, Ti, and mixtures thereof, and when the doping material comprises In as metal element, The ratio Zr (or Ti):In may range from about 1:0.5 to about 1:5. These ratios have shown particularly advantageous in that it is obtained electrical properties being compatible with practical applications. In particular, the mobility obtained is enough for good semi-conductor properties.

The present process further comprises the step of depositing the doped-metal oxide solution onto a substrate. This step is called herein "deposition step". It is obtained a substrate coated with a metal oxide thin film.

The technique for depositing the metal oxide thin film onto the substrate may be chosen from the group consisting of spin-coating, dip-coating, spray-coating, inkjet, screen-printing; alternatively the technique for depositing the metal oxide thin film onto the substrate from the group may consist of spin-coating.

The deposition of the metal oxide thin film onto the substrate may be conducted at room temperature, under atmospheric conditions, and under controlled humidity. By "room temperature", it is meant a temperature ranging from 18°C to 25°C. By "atmospheric conditions", it is meant an atmospheric pressure ranging from 900 hPa to 1100 hPa. By "controlled humidity", it is meant a relative humidity ranging from 20 % to 60 %.

It may be obtained a thin film deposited onto the substrate, wherein said thin film has a thickness ranging from about 10nm to about 500nm; preferably from about 20nm to about 200nm; more preferably from about 80nm to about 120nm. The thickness of the thin film may be measured using ellipsometry.

The substrate may be made of suitable materials. The substrate may be selected from the group consisting of glass, silicon, silicon dioxide, aluminium oxide, sapphire, germanium, gallium arsenide, an alloy of silicon and germanium, indium phosphide, plastic such as polyimide), textiles or their combinations thereof; alternatively the substrate is silicon.

The present process further comprises the step of patterning the coated substrate by irradiating it with deep ultra-violet (DUV) wavelengths. This step is called herein "patterning step". It is obtained a substrate having a patterned coating.

The technique for irradiating the film substrate may be a spatially-controlled irradiation; alternatively the technique may be photolithography using DUV lamp or lasers; alternatively the technique may be laser direct write lithography or interference lithography.

The use of laser lights has shown advantageous. Indeed, laser lights are directional, thus limiting the diffraction effects.

In a particular embodiment, the filmed substrate is irradiated via a laser emitting DUV wavelengths. The coated substrate may be irradiated at a UV wavelengths of about 300nm or less; alternatively at a UV wavelengths ranging from about 180nm to about 270nm; alternatively at a UV wavelengths of about 193nm +/- about 0,5 nm or at a UV wavelengths of about 244nm +/- about 0,5 nm, or at a UV wavelengths of about 266nm +/- about 0,5 nm.

UV wavelengths of about 193nm +/- about 0,5 nm may be obtained using an excimer laser like Braggstar from Coherent, loaded with ArF premix gaz.

UV wavelengths of about 248nm +/- about 0,5 nm may be obtained using an excimer laser like Braggstar from Coherent, loaded with KrF premix gaz.

UV wavelengths of about 244 nm +/- about 0,5 nm may be obtained using a doubled frequency ion argon laser like Inova 70-C from Coherent.

UV wavelengths of about 266nm +/- about 0,5 nm may be obtained using a doubled frequency Nd:YAG like Verdi from Coherent.

The metal oxide thin film, coated onto the substrate, is irradiated from 0.01 sec to 1000 sec.

The irradiation may be implemented using masks. Suitable masks may either be shadow masks (e.g. absorbing medium with open parts), metal mask (metal being Chromnium, gold, silver...), phase masks, or direct write with focalized beam scanning the surface.

The present process further comprises the step of immersing the substrate comprising a patterned coating into a development media. This step is called herein "development step". It is obtained a developed patterned substrate.

The development media may be an organic solvent; alternatively the development media may be selected from the group consisting of an alcohol, cyclohexanone, and mixtures thereof; alternatively selected from the group consisting of ethanol, 2-methoxyethanol, propanol, isopropanol, cyclohexanone and mixtures thereof. Alternatively, the development media may be an aqueous solution; alternatively an acid aqueous solution or a basic aqueous solution.

The patterned substrate may be immersed into the organic solvent from 1sec to 180sec.

The present process further comprises the step of post-annealing the developed patterned substrate. This step is called herein "post-annealing step". It is obtained a fully inorganic patterned substrate.

The developed patterned substrate may be post-annealed by thermal and/or photochemical treatment.

The thermal treatment may be carried out at a temperature ranging from about 100°C to about 800°C; preferably at a temperature ranging from about 250°C to about 600°C; more preferably at a temperature ranging from about 300°C to about 450°C.

The thermal treatment may be carried out from about 0.1h to about 2h; preferably from about 1h to about 2h.

The photochemical treatment may be carried out using a DUV light source (lamp/laser), during about 1 sec to about 6 hours; alternatively for about 1 hour.

In a particular embodiment, the thermal treatment and the photochemical treatment are carried out simultaneously.

Prior deposition of the metal oxide thin film onto the substrate, the present process may further comprise the step of treating the surface of the substrate, alternatively the step of functionalizing the surface of the substrate; alternatively the step of functionalizing the surface of the substrate with a treatment preventing dewetting. The treatment preventing dewetting may be selected from the group consisting of UV-ozone treatment, chemical treatment by pirana solution or deposition of a self-assembled monolayer. It is obtained therefore a surface-treated substrate.

Alternatively, prior deposition of the metal oxide thin film onto the substrate, the present process may be free of any step of treating the surface of the substrate. It is provided therefore a non-surface treated substrate.

The present process may be implemented in the absence of photoresists and/or etchants. This is possible as the functional material is integrated by direct writing, which simplifies the process. In particular, etching may be carried out by chemical or physical process, requiring complex setups and aggressive conditions that would be incompatible with delicate substrates. Furthermore, removal of the photoresist on the electrical material may be difficult without the use of a complex process, while the presence of a residual photoresist layer is an issue as it alters the electrical contact between the electrical material and electrodes in a device.

The present process may be free of any step of etching.

Substrates, onto which a patterned metal-oxide thin films is deposited, are obtained with the process described hereinbefore.

It is also obtained semiconductor articles comprising substrates, onto which a patterned metal-oxide thin films is deposited, by implementation of the process described hereinbefore.

### EXAMPLE

A process for obtaining patterned metal-oxide thin films deposited onto a substrate is detailed hereinafter.

Complexation and partial condensation steps - Preparation of a metal oxide chelate solution, and then a metal oxo-cluster solution

For the obtaining of a zirconium oxo-cluster solution, the following materials are provided:
- [metal oxide precursor] Zirconium (IV) propoxide solution (70wt%) in 1-propanol
- [ligand] Methacrylic acid (99%)
- [alcoholic solvent] 1-propanol (ACS reagent, anhydrous, 99,7%)
- hydrochloric acid (ACS reagent, 37%)

1mL of Zr (IV) propoxide solution and 2mL of Methacrylic acid are mixed, before agitation for 5 minutes. 2mL of 1-propanol is then added to the mixture obtained, before agitation for 10min. 0,9mL of water (HCl = 0,37M) is then added, before agitation for 60min. After a 24h resting time, a determined amount (between about 0 and 8mL, depending on the film thickness targetted) of 1-propanol is added to the rested mixture, before agitation for 10min.

For the obtaining of a titanium oxo-cluster solution, the following materials are provided:
- [metal oxide precursor] Titanium (IV)-isopropoxide solution (97wt%)
- [ligand] Methacrylic acid (99%)
- [alcoholic solvent] 1-propanol (ACS reagent, anhydrous, 99,7%)
- hydrochloric acid (ACS reagent, 37%)

1mL of Zr (IV) propoxide solution and 2mL of Methacrylic acid are mixed, before agitation between 5 minutes. 2mL of 1-propanol is then added to the mixture obtained, before agitation for 10min. 0,9mL of water (HCl = 0,37M) is then added, before agitation for 60min. After a 24h resting time, a determined amount (between about 0 and 8mL, depending on the viscosity expected) of 1-propanol is added to the rested mixture, before agitation for 10min.

### Doping step

The following material is provided:
- [doping material comprising a metal element] Indium (III) nitrate hydrate 99.9% trace metal basis

Three doped-metal oxide solutions are prepared, using different ratios of Zr (or Ti) and In i.e. ratio 1:1, ratio 1:2 and ratio 1:5 respectively.

For the ratio 1:1, 2mL of the Zr (or Ti) oxo-cluster solution is mixed with respectively 0,09mL of Indium (III) nitrate hydrate, before agitation for 24h.

For the ratio 1:2, 2mL of the Zr (or Ti) oxo-cluster solution is mixed with respectively 0,18mL of Indium (III) nitrate hydrate, before agitation for 24h.

For the ratio 1:1, 2mL of the Zr (or Ti) oxo-cluster solution is mixed with respectively 0,45mL of Indium (III) nitrate hydrate, before agitation for 24h.

### Deposition step

The Zr doped-metal oxide solution is deposited onto a substrate using the spin-coating technique at 6000rpm for 60sec. Three different thicknesses are achieved i.e.:
- Ratio 1:1 - thickness of 47nm
- Ratio 1:2 - thickness of 54nm
- Ratio 1:5 - thickness of 65nm.

Thickness is measured by spectroscopic ellipsometry, using an Uvisel Jobin-Yvon ellipsometer (spectral range 190-830 nm).

### Patterning, development and post-annealing steps - Obtaining of a fully inorganic patterned substrate

The patterning of the coated substrate was carried out, by irradiation with a DUV laser or lamp with binary chromium masks or fused silica phase masks. It is used either a DUV laser being ArF laser (Braggstar from Coherent) emitting at 193 nm, or a DUV lamp being a Hamamatsu LC8 high intensity mercury-xenon lamp equipped with a waveguide.

The following material is provided:
- [Development media] cyclohexone and ethanol, in a volumic ratio of 9:1, with Cyclohexanone (ACS reagent, >99.0%)

Obtaining of a fully inorganic patterned film, by irradiation using a UV lamp (Zr, Ti), was carried out as follows:
- Irradiation time of 15sec for the doped-metal oxide solution (ratio 1:1); 30sec for the doped-metal oxide solutions (ratio 1:2); 30sec for the doped-metal oxide solutions (ratio 1:5); then
- Development with cyclohexone/ethanol (ratio of 9:1) for 30sec; then
- Post-annealing for 1 hour at 400°C

Obtaining of a fully inorganic patterned film (Zr) with periodic patterns of 600 nm, by irradiation using a UV laser, was carried out as follows:
- Irradiation of the In-doped ZrO₂ solution at 25mJ, for a laser delivering 2 mW; then
- Development with cyclohexanone for 30sec; then
- Post-annealing for 1hour at 400°C

Obtaining of a fully inorganic patterned film (Ti) with periodic patterns of 600 nm, by irradiation using a UV laser, was carried out as follows:
- Irradiation of the In-doped TiO₂ solution at 10mJ, for a laser delivering 2 mW; then
- Development with cyclohexone for 30sec; then
- Post-annealing for 1hour at 400°C

### Mask Lithography

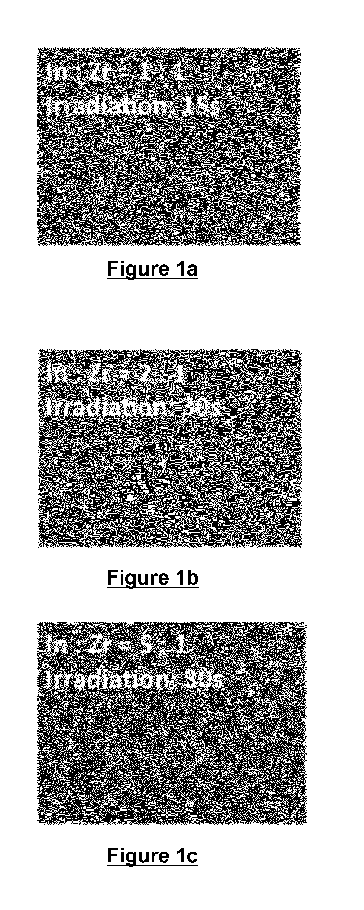

In Figures 1a, 1b and 1c, it is shown patterned metal-oxide thin films deposited onto the substrate (30x30 micron squares), when using three In-doped ZrO₂ solutions are prepared, using respectively the Zr:In ratios of 1:1 (figure 1a), 1:2 (figure 1b) and ratio 1:5 (figure 1c).

### Laser Interferometry Lithography

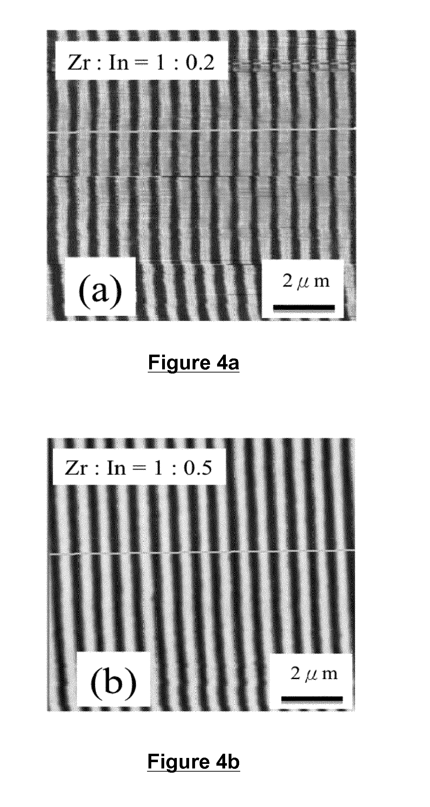

In Figures 4a and 4b, it is shown patterned metal-oxide thin films deposited onto the substrate, when using two In-doped ZrO₂ solutions prepared using respectively the Zr:In ratios of 1:0.2 (figure 4a), and ratio 1:0.5 (figure 4b).

### Effect of In-doping on electrical properties

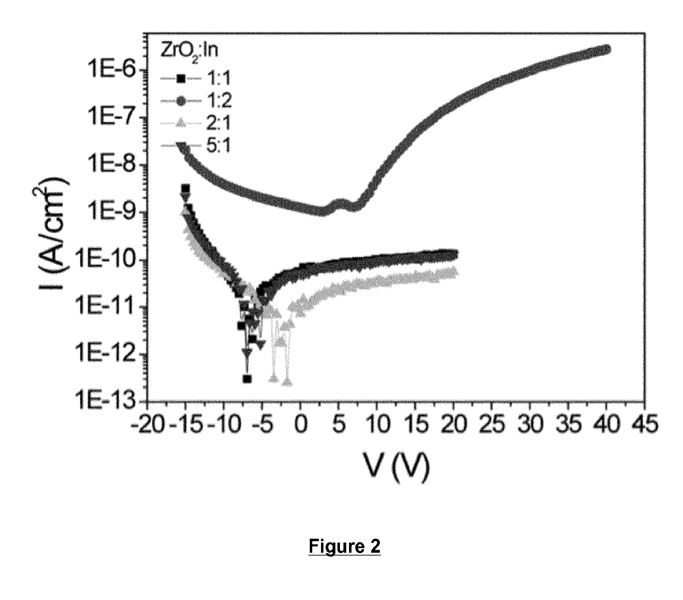

The electric properties of metal-oxide thin films deposited, when using four In-doped ZrO₂ solutions (respectively ratios 1:1, 1:2, 2:1, 5:1), have been assessed. Thermal annealing of the samples have been carried out at 400°C. Particularly, it has been measured the electric current density (A/cm2) in function of the voltage (V). Figure 2 is a graphic representation of the measurements made on three of metal-oxide thin films deposited onto the substrate, for In-doped ZrO₂ solutions.

### Effect of curing temperature

The effect of the curing temperature of metal-oxide thin films deposited, when using an In-doped ZrO₂ solution at ratio 1:2, has been assessed. Particularly, it has been measured ABSID (which represents the absolute value of drain current with the unit as ampere) in function of SQRTID (A^{0.5}) (which represents the square root of the absolute value of the drain current, with the unit as the square root of ampere).

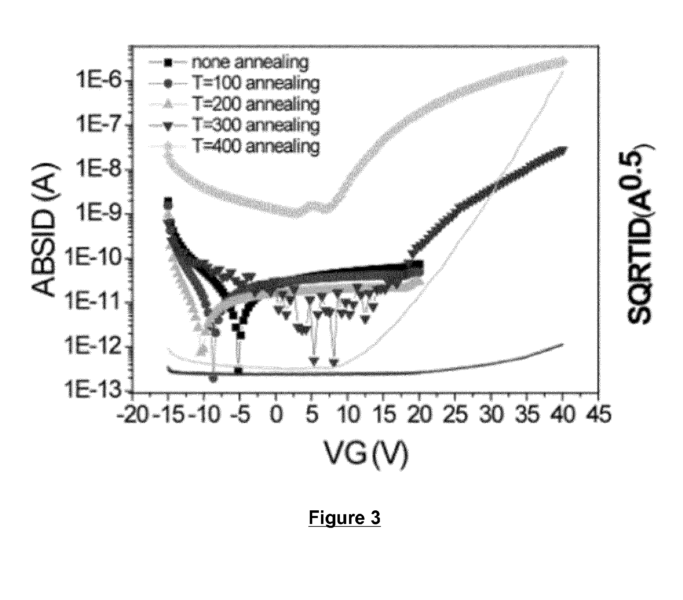

Figure 3 is a graphic representation of the measurements made on In-doped ZrO₂ solutions (1:2) and represents the experimental transfer characteristics from preliminary tests. The plots show the absolute value of the drain current (in log scale, Ampere) and the square root of the absolute value of the drain current (square root of Ampere) in function of the gate voltage (Volt).

The data obtained show that for temperature higher than 300°C, semiconducting properties are obtained. Mobility as 0.03 cm2/Vs was obtained.

To be specific, the following data were obtained with an annealing temperature of 400°C.

| Sample | Length (µm) | VT (V) | Von (V) | µ (cm²/Vs) | µ max (cm²/Vs) | S.S. (V/dec.) | On/Off |
|---|---|---|---|---|---|---|---|
| 400 anneal. | 300 | 14.02 | 7 | 0.03 | 0.05 | 4.95 | 2.10E +03 |

The table lists some typical parameters of a InZrOx TFT fabricated by using the proposed method with a following 400C thermal annealing. The transistor demonstrates normal on and off operation with mobility as 0.03 cm2/Vs. The results show the feasibility to realize TFT by using the proposed material and the proposed process.

## Claims

1. A process for obtaining patterned metal-oxide thin films deposited onto a substrate, said process comprising the steps of:
- preparing a metal oxide chelate solution by complexing metal oxide precursors with a ligand in an alcoholic solvent, wherein the ligand is methacrylic acid, for obtaining a metal oxide chelate;
- preparing a metal oxo-cluster solution by submitting the metal oxide chelate solution to water hydrolysis, for obtaining a partially-condensed metal oxide chelate;
- preparing a doped-metal oxide solution by doping the metal oxo-cluster solution with a doping material comprising a metal element;
- depositing the doped-metal oxide solution onto a substrate, for obtaining a substrate coated with a metal oxide thin film;
- patterning the coated substrate by irradiating it with deep ultra-violet (DUV) wavelengths, for obtaining a patterned coating;
- immersing the substrat comprising a patterned coating into a development media, for obtaining a developed patterned substrate;
- post-annealing the developed patterned substrate, for obtaining a fully inorganic patterned substrate.

2. A process, according to claim 1, wherein the metal oxide precursors comprise metal elements selected from the group consisting of zirconium (Zr), titanium (Ti), hafnium (Hf), zinc (Zn), aluminium (Al), and mixtures thereof; alternatively selected from the group consisting of Zr, Ti, and mixtures thereof.

3. A process, according to any preceding claims, wherein the metal oxide precursors are selected from the group consisting of metal alcoxide, metal acetate, metal citrate dihydrate, metal acetate dihydrate, metal acetylacetonate hydrate, metal acrylate, metal chloride, metal diethyldithiocarbamate, metal dimethyldithiocarbamate, metal fluoride, metal fluoride hydrate, metal hexafluoroacetylacetonate dihydrate, metal methacrylate, metal nitrate hexahydrate, metal nitrate hydrate, metal trifluoromethanesulfonate, metal undecylenate, metal trifluoroacetate hydrate, metal tetrafluoroborate hydrate, metal perchlorate hexahydrate, and mixtures thereof; alternatively selected from the group consisting of metal alcoxide ; alternatively selected from the group consisting of metal propoxide, metal isopropoxide, and mixtures thereof; alternatively selected from the group consisting of Zr(O-i-Pr)₄, Hf(O-i-Pr)₄, Ti(O-i-Pr)₄, Zn(O-i-Pr)₄, Al(O-i-Pr)₄ and mixtures thereof.

4. A process, according to any preceding claims, wherein the doping material comprises a metal element selected from the group consisting of indium (In), gallium (Ga), tin (Sn), thallium (Tl), copper (Cu), and mixtures thereof; preferably wherein the metal element is In.

5. A process, according to any preceding claims, wherein the doping material is selected from the group consisting of metal nitrate, metal chloride, metal chloride tetrahydrate, metal fluoride, metal fluoride trihydrate, metal hydroxide, metal acetate hydrate, metal acetylacetonate, metal acetate, metal chloride pentahydrate, metal cyclopentadienide, metal formate, metal hexafluoroacetylacetonate, metal trifluoroacetate, metal perchlorate hydrate, and mixtures thereof; preferably wherein the doping material is metal nitrate.

6. A process, according to any preceding claims, wherein the doping material is In(NO₃)₃.

7. A process, according to any preceding claims, wherein the alcoholic solvent is selected from the group consisting of propanol, isopropanol, 2-methoxyethanol, ethanol, methanol, dimethylformamide, acetylacetone, dimethylamineborane, acetonitrile, cyclohexane, and mixtures; alternatively selected from the group consisting of propanol, isopropanol, 2-methoxyethanol, ethanol, methanol and mixtures thereof.

8. A process, according to any preceding claims, wherein the technique for depositing the metal oxide thin film onto the substrate is chosen from the group consisting of spin-coating, dip-coating, spray-coating, inkjet, screen-printing; alternatively wherein the technique for depositing the metal oxide thin film onto the substrate is chosen from the group consisting of spin-coating.

9. A process, according to any preceding claims, wherein the deposition of the metal oxide thin film onto the substrate is conducted at room temperature, under atmospheric conditions, and under controlled humidity.

10. A process, according to any preceding claims, wherein the thin film deposited onto the substrate has a thickness ranging from 10nm to 500nm; preferably from 20nm to 200nm; more preferably from 80nm to 120nm.

11. A process, according to any preceding claims, wherein the substrate is made of materials selected from the group consisting of glass, silicon, silicon dioxide, aluminium oxide, sapphire, germanium, gallium arsenide, an alloy of silicon and germanium, indium phosphide, plastic such as polyimide), textiles or their combinations thereof; alternatively the substrate is silicon.

12. A process, according to any preceding claims, wherein the technique for irradiating the film substrate is a spatially-controlled irradiation; preferably the technique is photolithography using DUV lamp or lasers; more preferably the technique is laser direct write lithography or interference lithography.

13. A process, according to any preceding claims, wherein the coated substrate is irradiated via a laser emitting DUV wavelengths.

14. A process, according to any preceding claims, wherein the coated substrate is irradiated at a UV wavelengths of 300nm or less; preferably at a UV wavelengths ranging from 180nm to 270nm; more preferably at a UV wavelength of 193nm +/- 0,5 nm or alternatively at a UV wavelength of 244nm +/- 0,5 nm, or alternatively at a UV wavelength of 266nm +/- 0,5 nm.

15. A process, according to any preceding claims, wherein the development media is an organic solvent; preferably an alcohol, cyclohexanone, and mixtures thereof; more preferably wherein the organic solvent is selected from the group consisting of ethanol, 2-methoxyethanol, propanol, isopropanol, cyclohexanone and mixtures thereof.

16. A process, according to any preceding claims, wherein the patterned substrate is immersed into the organic solvent from 1 sec to 180sec.

17. A process, according to any preceding claims, wherein the developed patterned substrate is post-annealed by thermal and/or photochemical treatment.

18. A substrate, onto which a patterned metal-oxide thin films is deposited, said patterned thin-film being obtained with the process according to any of the preceding claims.

19. A semiconductor device comprising a substrate, onto which a patterned metal-oxide thin films is deposited, according to claim 18.
